# EUROPÄISCHE PATENTSCHRIFT

(11) **EP 1 384 288 B1**
(45) Veröffentlichungstag und Bekanntmachung des Hinweises auf die Patenterteilung: **01.12.2004**
(21) Anmeldenummer: 02727399.4
(22) Anmeldetag: 12.03.2002
(51) Int. Cl.: H01R 3/00

(54) **LEITUNGSVERBINDER, INSBESONDERE FÜR ELEKTRIZITÄTSZÄHLER**
LINE CONNECTOR, ESPECIALLY FOR AN ELECTRIC METER
CONNECTEUR, NOTAMMENT POUR COMPTEUR LECTRIQUE

(30) Priorität: 14.03.2001 DE 20104413 U
(43) Veröffentlichungstag der Anmeldung: 28.01.2004
(73) Patentinhaber: Actaris Zähler & Systemtechnik GmbH, 31785 Hameln (DE)
(72) Erfinder: HÜSKES, Rudi, 31020 Salzhemmendorf (DE); BÜTHE, Karl-Heinz, 31855 Aerzen (DE); RESKE, Peter, 13595 Berlin (DE)
(74) Vertreter: Döring, Roger, Dipl.-Ing.
(86) Internationale Anmeldenummer: PCT/EP2002/002688
(87) Internationale Veröffentlichungsnummer: WO 2002/073742

(56) Entgegenhaltungen:
- CH-A- 87 834
- DE-C- 973 551

## Beschreibung

Die Erfindung bezieht sich auf Leitungsverbinder, insbesondere für Elektrizitätszähler, mit einem aus Metall bestehenden, länglichen Verbinderkörper, der an seinem äußeren Endbereich mindestens eine Klemmschraube zum elektrisch leitenden Anschließen einer Eingangsleitung und an seinem inneren Endbereich einen Anschlussbereich für eine Kontaktschiene o. ä. aufweist, und der an seiner Unterseite eine Auflagefläche bildet, mit der er im eingebauten Zustand auf einer Gehäusewand aufliegt. Ein solcher Leitungsverbinder ist im Dokument DE-C-973551 offenbart.

Derartige Leitungsverbinder werden beispielsweise in Elektrizitätszählern eingesetzt, um an ihrem äußeren Endbereich eine Eingangsleitung anzuklemmen und an ihrem inneren Endbereich, beispielsweise mittels einer Klemmschraube, eine Kontaktschiene elektrisch leitend zu befestigen.

Im Betrieb entsteht infolge des nicht idealen Stromübergangs zwischen Anschlussbereich und Kontaktschiene o. ä. eine Erwärmung, die selbstverständlich um so größer ist, je größer der Stromfluss ist und je weniger die Wärme infolge der Einbausituation des Leitungsverbinders abgeführt werden kann. So hat sich gezeigt, dass bei Einbau eines Leitungsverbinders der interessierenden Art in das aus Kunststoff bestehende Unterteil des Gehäuses eines Elektrizitätszählers und seitlicher Umschließung des Leitungsverbinders durch Wandabschnitte des Gehäuseunterteils eine solche Erwärmung auftreten kann, dass bei Strömen von etwa 120 A die Temperatur in diesem Gehäusebereich in unzulässiger Weise ansteigt.

Es ist daher Aufgabe der Erfindung, einen Leitungsverbinder so auszubilden, dass auch bei hohen Stromflüssen eine unzulässige Erwärmung vermieden wird.

Zur Lösung dieser Aufgabe wird ein Leitungsverbinder der eingangs erwähnten Art erfindungsgemäß derart ausgestaltet, dass die Unterseite des Verbinderkörpers zwischen dem Ende der Auflagefläche und zumindest seinem inneren Endbereich eine gegenüber der Auflagefläche in Richtung auf seine Oberseite versetzte untere Fläche aufweist und dass zwischen dem am inneren Endbereich vorgesehenen Anschlussbereich und dem Ende der Auflagefläche eine sich zwischen Oberseite und Unterseite des Verbinderkörpers erstreckende Durchgangsöffnung vorgesehen ist, wobei sich vorzugsweise die versetzte untere Fläche bis zur inneren Stirnwand des Verbinderkörpers erstreckt. Darüberhinaus kann am inneren Ende der Auflagefläche ein stufenförmiger Übergang zur versetzten unteren Fläche des Verbinderkörpers vorgesehen sein.

Bei dem erfindungsgemäßen Verbinderkörper ist somit zwischen der durch die Auflagefläche gebildeten Auflageebene des Verbinderkörpers und seinem durch den Stromübergang einer besonderen Erwärmung unterliegenden Bereich eine Aussparung gebildet, so dass im montierten Zustand zwischen der die Auflagefläche für den Verbinderkörper bildenden Gehäusewand und dem Verbinderkörper ein Freiraum vorhanden ist, der über die Durchgangsöffnung mit der Oberseite sowie dem Gehäuseraum oberhalb des Verbinderkörpers in Verbindung steht. Daher kann infolge der Erwärmung des Verbinderkörpers erwärmte Luft von der Unterseite des Verbinderkörpers durch die Durchgangsöffnung nach oben abfließen, und kühlere Luft kann um den Verbinderkörper herum in den Bereich unterhalb des Verbinderkörpers zurückströmen, wodurch eine Kühlung desjenigen Bereichs des Verbinderkörpers bewirkt wird, der ganz besonders der Erwärmung infolge Stromdurchgangs ausgesetzt ist. Dabei reicht die erzeugte Luftzirkulation aus, um einen unzulässigen Temperaturanstieg zu verhindern, da es für den Einzelfall möglich ist, sowohl die Abmessungen der versetzten Auflagefläche als auch den Querschnitt der Durchgangsöffnung an die erforderliche Wärmeabfuhr anzupassen.

Um einen einfachen Aufbau zu erreichen, kann die versetzte untere Fläche eben sein und parallel zur Auflagefläche des Verbinderkörpers verlaufen. Derartige ebene Flächen lassen sich insbesondere einfach spanend herstellen.

Bei einem Leitungsverbinder, bei dem der am inneren Endbereich vorgesehene Anschlussbereich an der Oberseite des Verbinderkörpers eine in Richtung auf dessen Unterseite versetzte Kontaktfläche aufweist, in der eine Gewindebohrung vorgesehen ist und auf die im montierten Zustand mittels einer in die Gewindebohrung eingesetzten Klemmschraube eine Kontaktschiene o. ä. aufgepresst werden kann, kann sich die Durchgangsöffnung, die selbstverständlich nicht von der Köntaktschiene o.ä. überdeckt sein soll , mit einem Teil durch die Kontaktfläche und mit ihrem anderen Teil durch den an die Kontaktfläche anschließenden Bereich des Verbinderkörpers erstrecken, wodurch der im an die Kontaktfläche anschließenden Bereich des Verbinderkörpers liegende, an der Oberseite des Verbinderkörpers endende freie Wandabschnitt der Durchgangsöffnung eine zusätzliche, von der zirkulierenden Luft überstrichene Wärmeabgabefläche bildet.

Die Erfindung wird im folgenden anhand der ein Ausführungsbeispiel zeigenden Figuren näher erläutert.
- Figur 1: zeigt in perspektivischer Darstellung einen Leitungsverbinder.
- Figur 2: zeigt den Leitungsverbinder aus Figur 1 in einer Seitenansicht.
- Figur 3: zeigt den Leitungsverbinder aus den Figuren 1 und 2 in einer Draufsicht.
- Figur 4: zeigt den Leitungsverbinder aus den Figuren 1 bis 3 in einer Endansicht.
- Figur 5: zeigt in einem Teilschnitt und schematisch den in das teilweise dargestellte Gehäuse eines Elektrizitätszählers eingesetzten Leitungsverbinder gemäß Figuren 1 bis 4.

Der dargestellte Leitungsverbinder hat einen länglichen Verbinderkörper 1, der üblicherweise aus Messing besteht und der eine äußere Stirnwand 3, eine innere Stirnwand 6, eine an der Unterseite vorgesehene Auflagefläche 8 und eine an der Oberseite vorgesehene Fläche 11 aufweist. Durch die äußere Stirnwand 3 erstreckt sich eine Aufnahmeöffnung 4 in den Verbinderkörper 1 und bildet einen Anschlussbereich, in den quer sich zwei Klemmschrauben 15, 16 erstrecken, die im montierten Zustand beispielsweise eine elektrische Zuleitung klemmend und elektrisch leitend mit dem Verbinderkörper 1 verbinden.

Von der inneren Stirnwand 6 des Verbinderkörpers 1 verläuft an der Oberseite eine Kontaktfläche 12, die gegenüber der an der Oberseite vorgesehenen Fläche 11 nach unten in Richtung auf die Unterseite versetzt ist, und an der Unterseite eine untere Fläche 9, die gegenüber der an der Unterseite gebildeten ebenen Auflagefläche 8 in Richtung auf die Oberseite 11 versetzt ist. Die Kontaktfläche 12 geht über eine senkrecht zu ihr verlaufende Querfläche 13 stufenförmig in die an der Oberseite verlaufende Fläche 11 über. Entsprechend geht die an der inneren Stirnwand 6 beginnende untere Fläche 9 über eine senkrecht zu ihr verlaufende Querfläche 10 stufenförmig in die Auflagefläche 8 über. Der innere Endbereich 5 des Verbinderkörpers 1 bildet mit seiner Kontaktfläche 12 und der Gewindebohrung 17 einen Anschlussbereich für den noch zu beschreibenden Anschluss einer Kontaktschiene o. ä. Wie dargestellt, ist da die Kontaktfläche 12, die an der Querwand 13 endet, kürzer als die untere Fläche 9, da die Querfläche 10 näher an der äußeren Stirnwand 3 liegt als die Querfläche 13.

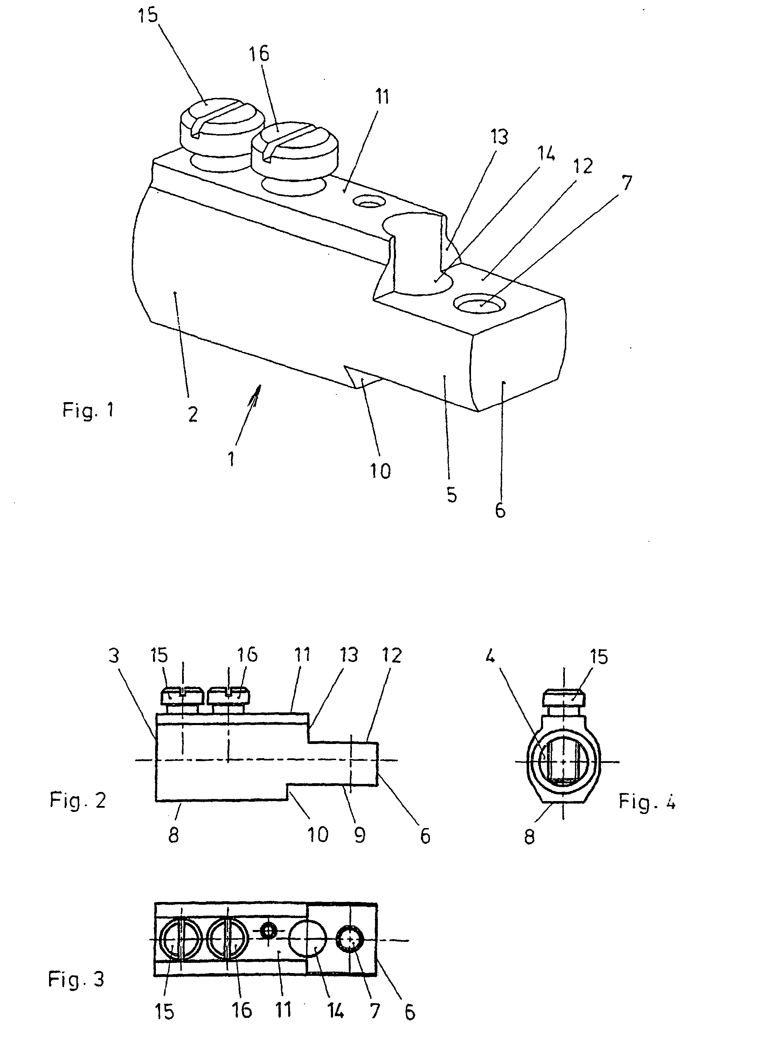

Eine Durchgangsöffnung 14 in Form einer Bohrung verläuft unmittelbar benachbart zur Querwand 10 durch die Fläche 9 und nach oben durch den gesamten Verbinderkörper 1, so dass sie, wie insbesondere in den Figuren 1 und 3 zu erkennen ist, etwa zur Hälfte in die Kontaktfläche 12 und zur Hälfte in die Fläche 11 an der Oberseite des Verbinderkörpers 1 reicht. Dadurch ergibt sich, wie Figur 1 zeigt, benachbart zur bzw. in der Querwand 13 in Fortsetzung der Durchgangsöffnung 14 eine frei liegende, halbzylindrische Wandfläche zwischen Kontaktfläche 12 und Fläche 11.

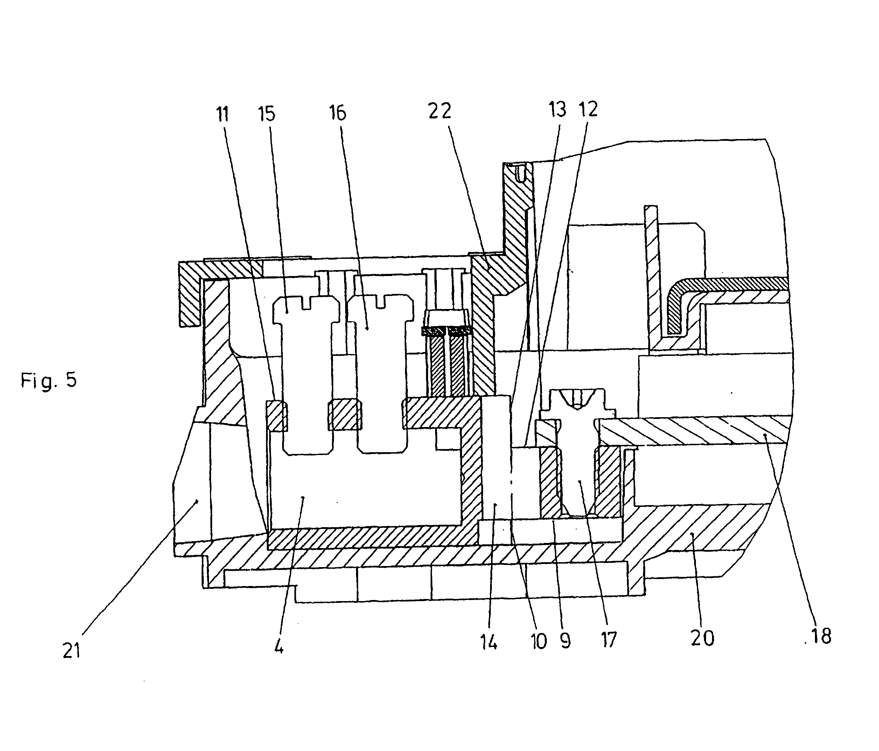

In Figur 5 ist in einem vereinfachten Schnitt ein Teil des Gehäuses eines Elektrizitätszählers dargestellt, das aus einem Unterteil 20 und einem Oberteil 22 besteht. In das Unterteil 20 ist ein Leitungsverbinder gemäß Figuren 1 bis 3 eingesetzt, so dass die an seinem äußeren Ende beginnende Bohrung 4 einer Durchgangsöffnung 21 des Unterteils 20 zugewandt ist. Durch diese Durchgangsöffnung 21 kann eine elektrische Zuleitung in die Bohrung 4 eingeführt und mittels der Klemmschrauben 15, 16 festgeklemmt werden, so dass eine elektrisch gut leitende und daher praktisch widerstandlose Verbindung zwischen elektrischem Leiter und Verbinderkörper 1 hergestellt wird. Am inneren Ende des Leiterkörpers 1 ist auf die Kontaktfläche 12 eine übliche Kontaktschiene 18 aufgesetzt und mittels einer in die Gewindebohrung 7 eingeschraubten Klemmschraube 17 befestigt. Die Kontaktschiene 18 endet benachbart zum der inneren Endfläche 5 näheren Rand der Durchgangsbohrung 14 und definiert den inneren Anschlußbereich.

Schon wegen der Art der Herstellung derartiger Kontaktschienen ist nicht sichergestellt, dass diese großflächig fest auf der Kontaktfläche 12 des Verbinderkörpers 1 aufliegt. Vielmehr ergibt sich beim Stromdurchgang ein gewisser Widerstand, der insbesondere bei großen Strömen zu einer erheblichen Erwärmung in diesem Bereich führt.

Wie Figur 5 zu entnehmen ist, liegt der Verbinderkörper 1 mit seiner Auflagefläche 8 auf einer vom Unterteil 20 des Gehäuses gebildeten Bodenwand auf, während im Bereich der unteren Fläche 9 des Verbinderkörpers 1 zwischen dieser Bodenwand und dem Verbinderkörper 1 ein Freiraum vorhanden ist. Dieser Freiraum steht in Verbindung mit der Durchgangsbohrung 14, so dass im Betrieb erwärmte Luft aus dem Freiraum durch die Durchgangsbohrung 14 und entlang dem halbzylindrischen Wandbereich der Querwand 13 strömen und kühlere Luft seitlich am inneren Bereich 5 des Verbinderkörpers 1 nach unten in den Freiraum und wieder durch die Durchgangsöffnung 14 zirkulieren kann. Diese Luftzirkulation führt zu einer wirksamen Kühlung des Verbinderkörpers 1.

## Patentansprüche

1. Leitungsverbinder, insbesondere für Elektrizitätszähler, mit einem aus Metall bestehenden, länglichen Verbinderkörper (1), der an seinem äußeren Endbereich (2) mindestens eine Klemmschraube (15, 16) zum elektrisch leitenden Anschließen einer Eingangsleitung und an seinem inneren Endbereich (5) einen Anschlussbereich (7, 12) aufweist, und der an seiner Unterseite eine Auflagefläche (8) bildet, mit der er im eingebauten Zustand auf einer Gehäusewand aufliegt, **dadurch gekennzeichnet, dass** der Verbinderkörper (1) zwischen dem Ende der Auflagefläche (8) und zumindest seinem inneren Endbereich (5) eine gegenüber der Auflagefläche (8) in Richtung auf seine Oberseite (11) versetzte untere Fläche (9) aufweist, und dass zwischen dem inneren Endbereich (5) und dem Ende der Auflagefläche (8) eine sich zwischen Oberseite und Unterseite erstreckende Durchgangsöffnung (14) vorgesehen ist.

2. Leitungsverbinder nach Anspruch 1, **dadurch gekennzeichnet, dass** am äußeren Ende der Auflagefläche (8) ein stufenförmiger Übergang zur versetzten unteren Fläche (9) des Verbinderkörpers (1) vorgesehen ist.

3. Leitungsverbinder nach Anspruch 1 oder 2, **dadurch gekennzeichnet, dass** sich die versetzte untere Fläche (9) bis zur inneren Stirnwand (6) des Verbinderkörpers (1) erstreckt.

4. Leitungsverbinder nach einem der Ansprüche 1 bis 3, **dadurch gekennzeichnet, dass** die versetzte untere Fläche (9) eben ist und parallel zur Auflagefläche (8) verläuft.

5. Leitungsverbinder nach einem der Ansprüche 1 bis 3, bei dem der am inneren Endbereich (5) vorgesehene Anschlussbereich an der Oberseite des Verbinderkörpers (1) eine in Richtung auf dessen Unterseite versetzte Kontaktfläche (12) aufweist, in der eine Gewindebohrung (7) vorgesehen ist, **dadurch gekennzeichnet, dass** sich die Durchgangsöffnung (14) mit einem Teil durch die Kontaktfläche (12) und mit ihrem anderen Teil durch den an die Kontaktfläche (12) anschließenden Bereich des Verbinderkörpers (1) erstreckt.

## Claims

1. A cable connector, especially for the use with electric meters, comprising an elongated metallic connector body (1), which has at its outer end area (2) at least one clamping screw (15,16) for electrically connecting an incoming conductor thereto and at its inner end area (5) a connecting area (7,12), and which further has on its underside a bearing surface (8) which abuts against a wall of a housing, **characterized in that** the connector body (1) has between the end of the bearing surface (8) and at least its inner end area (5) a lower plane (9) which is displaced with respect to the bearing surface (8) in the direction of its upper side (11), and that between the inner end area (5) and the end of the bearing surface (8) a throughhole (14) is provided which extends from the upper side (11) to the underside.

2. A cable connector according to claim 1, **characterized in that** at the outer end of the bearing surface (8) a stepped transition to the displaced lower plane (9) of the connector body (1) is provided.

3. A cable connector according to claim 1 or 2, **characterized in that** the displaced lower plane (9) extends up to the inner face wall (6) of the connector body(1).

4. A cable connector according to one of the claims 1 to 3, **characterized in that** the displaced lower plane (9) is planar and parallel to the bearing surface (8).

5. A cable connector according to one of the claims 1 to 4, to which at the connecting area of the inner end area (5) of the connector body (1) a displaced contacting area (12) is provided at its underside, which has a tapped hole (7), **characterized in that** one part of the throughhole (14) passes through the contacting area (12) and the other part thereof passes through that portion of the connector body (1) linking up with the contacting area (12).

## Revendications

1. Connecteur, en particulier pour compteur électrique, avec un corps de connecteur (1) longitudinal en métal présentant en son extrémité extérieure (2) au moins une borne à vis (15, 16) pour le raccordement conducteur d'un câble d'arrivée et en son extrémité intérieure (5) une zone de raccordement (7, 12), et qui forme, sur sa face inférieure, une surface d'appui (8) qui repose, lorsque le connecteur est monté, sur une paroi de boîtier, **caractérisé par le fait que** le corps de connecteur (1) présente entre l'extrémité de la surface d'appui (8) et au moins son extrémité intérieure (5) une surface inférieure (9) décalée par rapport à la surface d'appui (8) dans la direction de sa face supérieure (11 ) et **par le fait qu'**entre l'extrémité intérieure (5) et l'extrémité de la surface d'appui (8) est prévu un orifice traversant (14) s'étendant de la face supérieure à la face inférieure.

2. Connecteur selon la revendication 1, **caractérisé par le fait qu'**à l'extrémité extérieure de la surface d'appui (8) est prévu un échelon vers la surface inférieure (9) décalée du corps de connecteur (1).

3. Connecteur selon la revendication 1 ou 2, **caractérisé par le fait que** la surface inférieure (9) décalée s'étend jusqu'à la paroi avant intérieure (6) du corps de connecteur (1).

4. Connecteur selon l'une quelconque des revendications 1 à 3, **caractérisé par le fait que** la surface inférieure (9) décalée est plane et parallèle à la surface d'appui (8).

5. Connecteur selon l'une quelconque des revendication 1 à 3, dans lequel la zone de raccordement prévue à l'extrémité intérieure (5) présente sur la face supérieure du corps de connecteur (1) une surface de contact (12) décalée dans la direction de sa face inférieure et dans laquelle est prévu un filetage (7), **caractérisé par le fait que** l'orifice traversant (14) s'étend d'un côté à travers la surface de contact (12) et de l'autre côté à travers la zone du corps de connecteur (1) voisine de la surface de contact (12).
